Europäisches Patentamt

European Patent Office

Office européen des brevets

(19)

(11) Publication number : **0 131 024**
**B1**

# (12) EUROPEAN PATENT SPECIFICATION

(45) Date of publication of patent specification :
01.10.86

(51) Int. Cl.⁴ : **G 01 R 27/26**

(21) Application number : 84900387.6

(22) Date of filing : 06.01.84

(86) International application number :
PCT/DK 84/00002

(87) International publication number :
WO/8402760 (19.07.84 Gazette 84/17)

(54) CAPACITANCE MEASURING CIRCUIT.

(30) Priority : 07.01.83 DK 43/83

(43) Date of publication of application :
16.01.85 Bulletin 85/03

(45) Publication of the grant of the patent :
01.10.86 Bulletin 86/40

(84) Designated contracting states :
AT BE CH DE FR GB LI LU NL SE

(56) References cited :
DE-C- 2 712 369
GB-A- 2 006 442
US-A- 3 581 196
Industriell teknik nr 3. 1974, p. 27, patentprofylax 9/74,
"Kapacitansmätutrustning".

(73) Proprietor : EILERSEN, Nils Age Juul
Gongehusvej 226
DK-2950 Vedbaek (DK)

(72) Inventor : EILERSEN, Nils Age Juul
Gongehusvej 226
DK-2950 Vedbaek (DK)

(74) Representative : Patentanwälte Leinweber & Zimmermann
Rosental 7/II Aufg.
D-8000 München 2 (DE)

## Description

The invention relates to a capacitance measuring circuit comprising an oscillator circuit, where the capacitance to be measured forms a link of a series connected frequency-determining set of impedances, which is connected to the oscillator circuit only at the end terminals of the series connection, in the following referred to as the first end terminal and the second end terminal.

From DE-PS 2 712 369 C2 and from the periodical « Industriel Teknik » 3-1974, page 27, capacitance measuring oscillator circuits of the kind referred to are known in which a constant current is applied to the series connected set of impedances. In these circuits the voltage across the series connection varies continuously during each half-cycle, and the charge on the stray and input capacitances of the voltage detector will therefore vary during the whole of the half-cycle. This charge is to be delivered by a constant current generator belonging to the circuit, and the charging of the subject capacitance, and thereby the oscillator frequency, will therefore depend on changes of the size of the stray and input capacitances.

It is the object of the invention to devise an oscillator circuit of the kind referred to in such a manner as to be capable of measuring capacitances without undesired influence of stray and input capacitances, whereby a high stability and linearity of the measurement can be obtained.

This is achieved, according to the invention, by so arranging the circuit that the first end terminal is connected to a constant voltage, while the second end terminal is connected to a point of the oscillator circuit where that circuit maintains a constant voltage during each half-cycle, while at the same time sensing the charging current flowing into the capacitance so as to be triggered at the moment when the charging current thus sensed has dropped to a predetermined value.

It will be seen that when the voltage across the series connection is maintained constant in each half-cycle, the charge on the stray and input capacitances is likewise constant in each half-cycle, and since the recharging of the stray and input capacitances to the constant voltage takes place at the start of each half-cycle, the size of this constant charge and thereby the size of the stray and input capacitances has no influence on the subsequent charging of the subject capacitance and consequently no influence on the frequency of the oscillator circuit, which is representative of the value of the subject capacitance.

Thus, it is a distinguishing feature of the measuring circuit according to the invention that a constant voltage is applied to the frequency-determining series connected impedances, and the frequency is determined by measurement of the charging current of the capacitance, as contrasted to the known capacitance measuring circuits in which a constant current is applied to the frequency-determining series connected impedances, and the frequency is determined by measurement of the voltage.

From GB 2.006.442 A a capacitance measuring circuit is known in which the influence of the stray capacitances has been reduced by including the subject capacitance in an integrator connected to a Schmitt-trigger.

Here the series connection of the frequency-determining impedances is not connected to the measuring circuit at its end terminals only, but both terminals of the subject capacitance are connected directly to the output and the inverting input of the amplifier.

Hereby the stray capacitances to ground are in fact eliminated, but the coupling capacitance between the input and the output of the amplifier, which is frequently substantial, is in this case connected directly in parallel to the subject capacitance.

Since this coupling capacitance depends on many parameters, such as temperature, amplification, voltage supply etc., it will have an appreciable influence on the accuracy of measurement.

Besides, this capacitance measuring circuit cannot function with the most widespread group of capacitive transducers, viz. those having one terminal grounded.

The invention will now be described in further detail with reference to the drawing, in which

Figure 1 shows a particularly advantageous embodiment of the invention, in which the current-sensing, constant-voltage-maintaining circuit consists of an inverting operational amplifier in conjuction with a comparator,

Figure 2 a graph of the output voltage $U_K$ of the comparator of Fig. 1,

Figure 3 a graph of the output voltage $U_A$ of the operational amplifier of Fig. 1,

Figure 4 shows a capacitance measuring circuit according to the invention, illustrating a method of establishing the reference voltage for the comparator,

Figure 5 shows a capacitance measuring circuit according to the invention in which an inverting amplifier is inserted between the current-sensing operational amplifier and the comparator,

Figure 6 a graph of the output voltages $U_A1$ of the inverting amplifier of Fig. 5,

Figure 7 a graph of the output voltage $U_A$ of the comparator of Fig. 5,

Figure 8 a capacitance measuring circuit according to the invention in which the charging current for the series connected frequency-determining impedances is superposed on a constant current,

Figure 9 a capacitance measuring circuit according to the invention with alternative switching of a plurality of series connected frequency-determining sets of impedances to the same current-sensing operational amplifier, and

Figure 10 a capacitance measuring circuit according - to the invention with alternative switching of a plurality of current-sensing operational amplifiers to the same comparator and buffer.

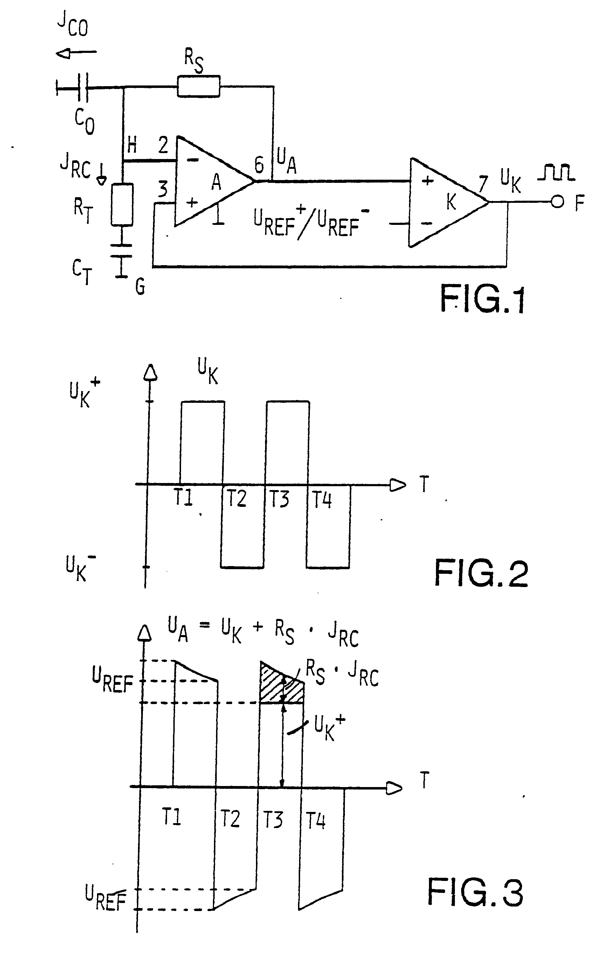

' In the capacitance measuring circuit of Fig. 1 one end terminal G of the series connected frequency-determining impedances $R_TC_T$ is connected to a fixed voltage, while their other end terminal H is connected to the inverting input 2 of an operational amplifier A, said input being also connected to the output 6 of the operational amplifier through a resistor $R_S$. The non-inverting input of a comparator K is connected to the output 6 of the operational amplifier, and the inverting input of the comparator is connected to a reference voltage which has the constant positive value $U_{REF}+$ and the constant negative value $U_{REF}-$ in the positive and the negative half-cycle respectively.

The output 7 of the comparator, which can only assume either the positive maximum voltage $U_K+$ or the negative maximum voltage $U_K-$, cf. the graph of Fig. 2, is connected to the non-inverting input 3 of the operational amplifier.

CO symbolizes the sum of the stray and input capacitances of the inverting input 2 of the operational amplifier.

Assuming the operational amplifier to be ideal, meaning in the present context that no current flows into the inputs 2 and 3, and that the feedback through $R_S$ causes the input 2 to assume exactly the same voltage as that applied to the input 3, the function of this capacitance measuring circuit is a follows :

At the time T1, $U_K$ is assumed to have its positive maximum value $U_K+$, which is also applied to the input 3 of the operational amplifier A.

The output 6 consequently assumes a positive voltage which through the resistor $R_S$ will raise the voltage on the input 2, and thereby the voltage across the series connection of $R_TC_T$, to the constant voltage $U_K+$.

This positive voltage change across the series connection will cause a current $J_{RC}$ to flow into $R_TC_T$.

Since no current flows into the input 2, the said current must be delivered via $R_S$, and the output voltage $U_A$ of the comparator must therefore assume the value $U_A = U_K^+ + R_S{}^J{}_{RC}$.

The current $J_{RC}$ drops exponentially, and thereby $U_A$ drops, and when suitably selecting the constant value $U_{REF}+$, which can advantageously be made proportional to $U_K+$, $U_A$ will pass $U_{REF}+$, and the output of the comparator will shift to its negative maximum value $U_K-$, which is now applied to the input 3 of the operational amplifier, cf. the graph of Fig. 3.

As a consequence, the output 6 will assume a negative voltage which through the resistor $R_S$ will lower the voltage on input 2 and thereby on the series connection $R_TC_T$ to the constant voltage $U_K-$.

This negative voltage change on the series connection $R_TC_T$ will cause a current $J_{RC}$ to flow out of $R_TC_T$, and, like before, this current must be delivered via $R_S$, and the output voltage $U_A$ will therefore assume the value $U_A = U_K^- — R_S{}^J{}_{RC}$.

Like before, the current drops exponentially, whereby $U_A$ drops, and when suitably selecting the reference voltage, which now has the constant negative value $U_{REF}-$, $U_A$ will pass $U_{REF}-$, and the output of the comparator will be shifted to its positive maximum value $U_K+$, which is again applied to the input 3. In this manner the oscillations continue at a frequency F determined by the time constant $R_TC_T$ in conjuction with the resistor $R_S$, the charging voltages $U_K+$ and $U_K-$ and the reference voltages $U_{REF}+$ and $U_{REF}-$, which with modern components can all be made very stable.

Owing to the fact that the operational amplifier, through the resistor $R_S$, has almost instantly upon the change-over imposed upon its inverting input 2 the same voltage $U_K$ as that applied to the input 3 from the comparator, the stray capacitance C0 has of course just as promptly been charged to the same constant voltage.

This charging has been effected by the superposition of a current $J_{C0}$ of very short duration on the current $J_{RC}$.

This current does not in any way affect the charging current $J_{RC}$, which is only determined by $C_T$ and the constant voltage $U_K$ and $R_T$, and seeing that, even in the case of great values of C0, the current $J_{C0}$ has dropped to 0 long before the charging current $J_{RC}$ reaches its shifting value, it will be seen that the charging of C0, and thereby the size of C0, has no influence on the frequency of this measuring circuit according to the invention.

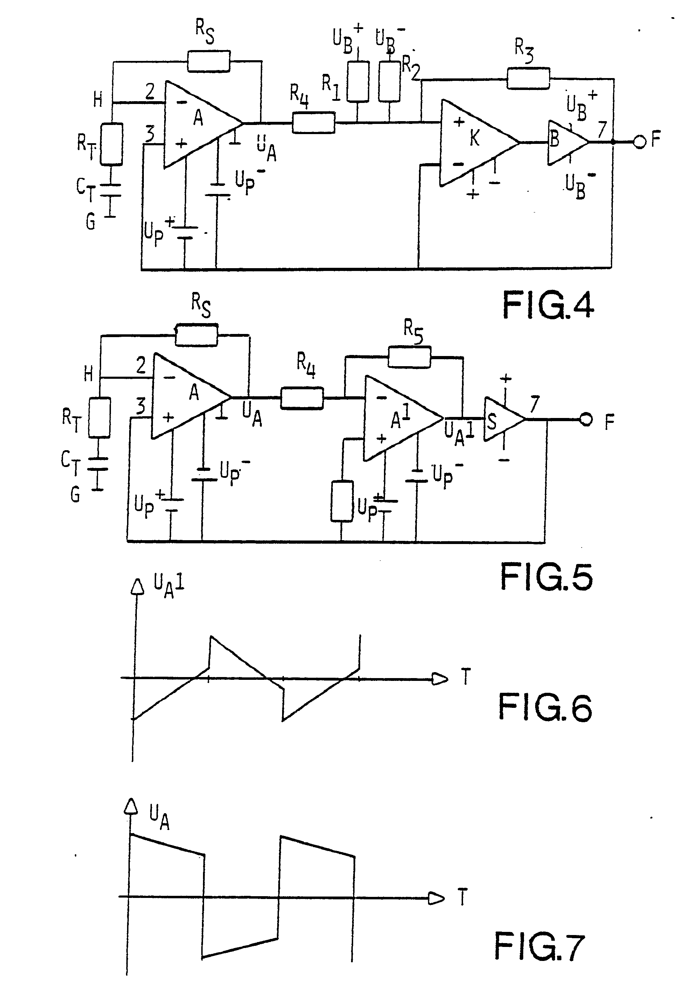

The oscillator circuit of Fig. 4 comprises a buffer amplifier B with the voltage supplies $U_B+$ and $U_B-$.

The buffer amplifier has the job of driving the terminal 3 of the operational amplifier A and possibly also of driving the associated frequency measuring equipment.

The comparator voltage $U_K$ has now been replaced by the buffer voltage $U_B$ and is, like before, connected to the input 3 of the operational amplifier A, and is also used as reference for the comparator K.

Since the output voltage of the operational amplifier is $U_A = U_B + R_S{}^J{}_{RC}$, it will be seen that if $U_A$ is directly applied to the non-inverting input of the comparator, the inputs of the comparator will assume the same voltage only when $J_{RC} = 0$, i. e. the comparator will not change over.

Therefore, a suitable voltage division of $U_A$ is established by means of the resistors $R_1$, $R_2$ and $R_4$, whereby the voltage on the input of the comparator will pass the reference $U_B$ when $J_{RC}$ has dropped to a suitable value.

The resistor $R_3$ has been provided in order to establish a positive feed-back in the comparator, in a manner known per se, so as to make the comparator change over quickly even if the voltage change on the non-inverting input is relatively slow.

The voltage supply $U_p+$ and $U_p-$ to the operational amplifier is so connected as to be bootstrapped with the input 3, when this is changed over between $U_B+$ and $U_B-$.

By this arrangement the advantage is obtained that the voltage on the output of the operational amplifier changes over more quickly since also the output follows $U_p+$, $U_p-$ and the input 3 when the buffer changes over between $U_B+$ and $U_B-$, and the operational amplifier therefore only has to contribute the voltage shift $R_S J_{RC}$. Besides, the advantage is obtained that common mode errors in the operational amplifier are avoided.

In the capacitance measuring circuit of Fig. 5, an inverting amplifier $A^1$ is inserted between the operational amplifier A and the Schmitt-trigger S, where the amplification is determined by the proportion of $R_4$ to $R_5$.

Since the voltage supply $U_p+$, $U_p-$ for both A and $A^1$ is bootstrapped with the output voltage of the Schmitt-trigger and thereby with the voltage on the input 3 of A, the graph of the output voltages $U_A$ and $U_A 1$ will be as shown in Figs. 6 and 7.

It will be seen that the graph of $U_A 1$ passes the value 0 at dropping current $J_{RC}$, and for this reason the comparator can be replaced by the Schmitt-trigger S which acts as a comparator with hysteresis and the reference voltage 0.

By this measuring circuit according to the invention the further advantage is obtained that the voltage supplied to the Schmitt-trigger/comparator is amplified.

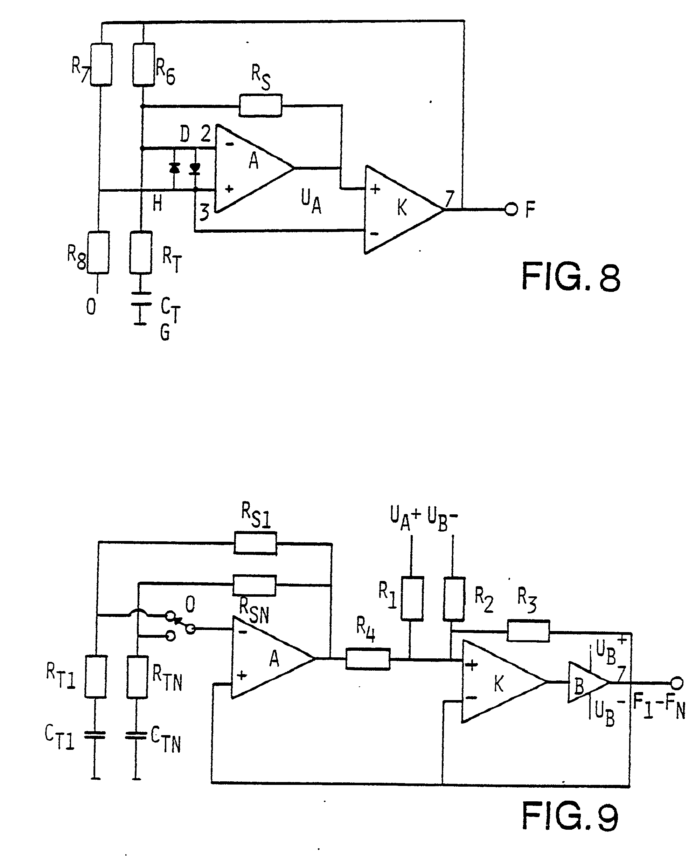

Another method of avoiding subdivision of the voltage $U_A$ and still making the input voltage of the comparator pass the reference voltage during the discharging of $C_T$ is shown in Fig. 8, where the resistor $R_6$ provides a constant positive and a constant negative current into the frequency-determining series connected impedances in the positive and the negative half-cycle, respectively.

When this current exceeds $J_{RC}$, the output voltage $U_A$ will shift in relation to the voltage on the input 3 of the operational amplifier and thereby in relation to the reference voltage of the comparator, which is determined by voltage division between $R_7$ and $R_8$.

Fig. 8 also shows two diodes D connected in anti-parallel and serving to obtain the fastest possible charging of the stray and input capacitances on input 2 of the amplifier A. This is of importance when these capacitances assume very high values so that a charging through $R_S$ alone will be too slow. These diodes can of course also be used in the other capacitance measuring circuits according to the invention shown in the drawing.

In the use of the capacitance measuring circuit according to the invention it is possible, as illustrated in Fig. 9, in a simple manner to connect a plurality of sets of series connected frequency-determined impedances $R_{T1}$, $C_{T1}$-$R_{TN.CTN}$ successively to the same current-sensing operational amplifier, seeing that, as explained above, the stray capacitances from supply conductors and switches have no influence on the frequencies $F_1$-$F_N$.

Hereby a succession of frequencies is obtained, which by suitable calculation, e. g. in a computer connected to the circuit, can be used for determining a function of the various capacitances $C_{T1}$-$C_{TN}$ and to eliminate drifting and ageing of the components common to a plurality of measurements, such as the amplifier A, the comparator K and the resistors $R_1$, $R_2$, $R_3$ and $R_4$.

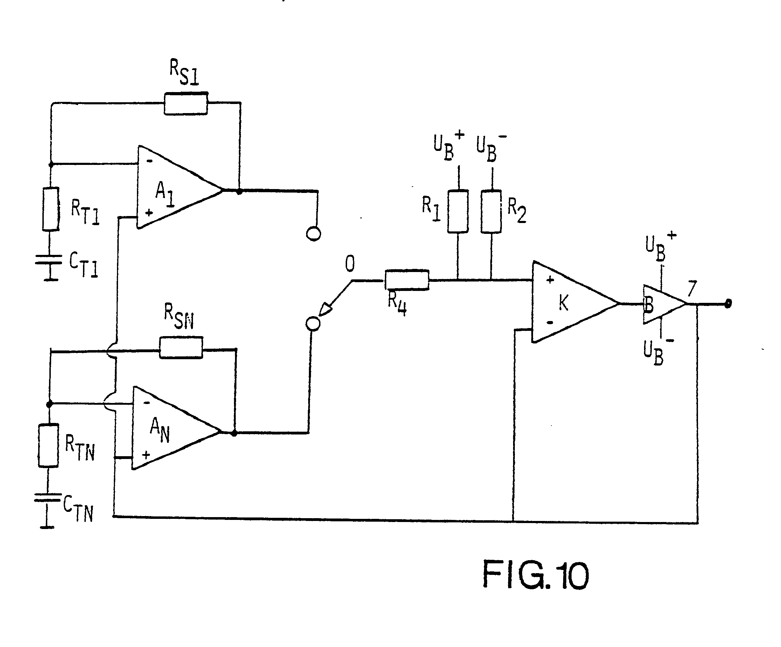

At high temperatures leakage currents from the switches in Fig. 9 may, however, affect the charging of the subject capacitances, and it may then be advantageous to connect two or more current-sensing operational amplifiers $A_1$-$A_N$ through a switch 0 to a common comparator K and buffer B, as shown in Fig. 10.

In the capacitance measuring circuit according to the invention, the series connected frequency-determining impedances may in principle be RC, LC or RCL combinations or mechanical resonators.

However, a great advantage is obtained by using a RC-oscillator, because the frequency of this is proportional to the electrode spacing of a capacitive transducer. This is, however, only the case when the influence from the stray and input capacitances can be eliminated, such as has been achieved by the present invention.

An advantage can also be obtained by connecting series connected reference impedance sets, having a fixed, known value, to a capacitance measuring circuit according to the invention in succession with the subject impedance sets. These reference impedance sets may deliver signals which can be utilized for the complete correction for drifting in the components common to a plurality of measurements, and for producing fault indication signals, if as a consequence of faults the signal frequencies from one or more subject impedance sets go beyond certain tolerances relatively to the reference frequencies.

The use of reference impedance sets also makes it possible to perform an accurate absolute measurement of capacitances.

In the practical use of the measuring circuit according to the invention it may be particularly advantageous to arrange the resistor $R_T$ with one supply terminal directly on the capacitor electrode of a capacitive transducer, whereby stray capacitances in the point of junction of the series connection are totally avoided.

The other end of $R_T$ may, owing to the advantageous properties of the capacitance measuring circuit, be connected to this circuit through a relatively long conductor, such as is in practice frequently desirable.

As will be seen, the measuring circuit according to the invention can in a simple manner provide a stable and linear measuring result which is accurately representative of the subjet capacitance.

**Claims**

1. Capacitance measuring circuit comprising an oscillator circuit, where the capacitance ($C_T$) to be measured forms a link of a series connected frequency-determining set of impedances ($R_T$, $C_T$), which is connected to the oscillator circuit only at the end terminals of the series connection, in the following referred to as the first end terminal and the second end terminal, characterized in that the first end terminal (G) is connected to a constant voltage, while the second end terminal (H) is connected to a point (2) of the oscillator circuit where that circuit maintains a constant voltage during each half-cycle while at the same time sensing the charging current flowing into the capacitance so as to be triggered at the moment when the charging current thus sensed has dropped to a predetermined value.

2. Capacitance measuring circuit according to claim 1, characterized in that the second end terminal (H) is connected to the inverting input (2) of a current-sensing operational amplifier (A) having an impedance ($R_S$) connected between its output (6) and its inverting input (2), and the output (6) is connected to a regenerative circuit in such a manner that upon dropping of the charging current to the capacitance ($C_T$), as sensed by the operational amplifier (A), to a predetermined value the output voltage triggers the regenerative circuit, which has an output (7) coupled back to the non-inverting input (3) of the current-sensing operational amplifier (A).

3. Capacitance measuring circuit according to claim 2, characterized in that the regenerative circuit comprises a comparator (K), the non-inverting input of which is coupled to the output (6) of the current-sensing operational amplifier while its inverting input is coupled to a source of positive and negative reference potential ($U_{REF}+/U_{REF}-$).

4. Capacitance measuring circuit according to claim 3, characterized in that the output of the comparator (K) is connected to the input of a buffer amplifier (B), the output of which constitutes the output (7) of the regenerative circuit and also serves as source of reference potential for the comparator (K).

5. Capacitance measuring circuit according to claim 3, characterized in that an inverting amplifier ($A^1$) is inserted between the current-sensing operational amplifier (A) and a Schmitt-trigger (S) which constitutes the comparator.

6. Capacitance measuring circuit according to any of the beforegoing claims, characterized in that a plurality of series connected frequency-determining sets of impedances ($R_{T1}$, $C_{T1}$-$R_T$-N, $C_{TN}$) are alternatively connectable to the same oscillator circuit by means of switches (0).

7. Capacitance measuring circuit according to any of claims 2-5, characterized in that the outputs of a plurality of current-sensing operational amplifiers ($A_1$-$A_N$) with frequency-determining sets of impedances ($R_{T1}$, $C_{T1}$-$R_{TN}$, $C_{TN}$) connected thereto are alternatively connectable to the same regenerative circuit by means of switches (0).

8. Capacitance measuring circuit according to any of the beforegoing claims, characterized in that the first end terminal (G) is connected to ground potential.

9. Capacitance measuring circuit according to claim 8, characterized in that the capacitance ($C_T$) to be measured is arranged at the end of the set of impedances ($R_T$, $C_T$) connected to ground potential.

**Patentansprüche**

1. Kapazitätsmesskreis, bestehend aus einem Oszillatorkreis, wo die zu messende Kapazität ($C_T$) ein Glied eines frequenzbestimmenden Satzes von reihengeschalteten Impedanzen ($R_T$, $C_T$) bildet, der nur an den Endanschlüssen der Reihenschaltung, im folgenden als der erste und der zweite Endanschluss benannt, mit dem Oszillator verbunden ist, dadurch gekennzeichnet, dass der erste Endanschluss (G) an eine konstante Spannung angeschlossen ist, während der zweite Endanschluss (H) mit einem Punkt (2) des Oszillatorkreises verbunden ist, wo dieser Kreis während jeder Halbperiode eine konstante Spannung aufrechterhält und gleichzeitig den in die Kapazität hineinfliessenden Ladestrom abfühlt, und zwar so, dass der Kreis in dem Augenblick, wo der so abgefühlte Ladestrom bis zu einem vorbestimmten Wert abgefallen ist, umgekippt wird.

2. Kapazitätsmesskreis nach Anspruch 1, dadurch gekennzeichnet, dass der zweite Endanschluss (H) mit dem invertierenden Eingang (2) eines stromabfühlenden Operationsverstärkers (A) verbunden ist, zwischen dessen Ausgang (6) und invertierenden Eingang (2) eine Impedanz ($R_S$) angeschlossen ist, während der Ausgang (6) derart mit einem Rückkopplungskreis verbunden ist, daß bei Abfall des durch den Operationsverstärker (A) abgefühlten Ladestroms zur Kapazität ($C_T$) bis zu einem vorbestimmten Wert die Ausgangsspannung den Rückkopplungskreis umkippt, wobei dieser Kreis einen Ausgang (7) aufweist, der an den nicht-invertierenden Eingang (3) des stromabfühlenden Operationsverstärkers (A) rückgekoppelt ist.

3. Kapazitätsmesskreis nach Anspruch 2, dadurch gekennzeichnet, dass der Rückkopplungskreis einen Komparator (K) aufweist, dessen nichtinvertierender Eingang an den Ausgang (6) des stromabfühlenden Operationsverstärkers gekoppelt ist, während sein invertierender Eingang an eine Quelle von positiver und negativer Bezugsspannung ($U_{REF}+/U_{REF}-$) gekoppelt ist.

4. Kapazitätsmesskreis nach Anspruch 3, dadurch gekennzeichnet, dass der Ausgang des Komparators (K) mit dem Eingang eines Pufferverstärkers (B) verbunden ist, dessen Ausgang den Ausgang (7) des Rückkopplungskreises bildet und zugleich als Bezugsspannungsquelle für den Komparator (K) dient.

5. Kapazitätsmesskreis nach Anspruch 3, dadurch gekennzeichnet, dass zwischen den stromabfühlenden Operationsverstärkers (A) und einen den Komparator bildenden Schmitt-Trigger (S) ein invertierender Verstärker (A¹) eingeschaltet ist.

6. Kapazitätsmesskreis nach einem der vorhergehenden Ansprüche, dadurch gekennzeichnet, daß eine Mehrzahl von reihengeschalteten frequenzbestimmenden Impedanzsätzen ($R_{T1}$, $C_{T1}$-$R_{Tn}$, $C_{TN}$) mit Hilfe von Schaltern (0) wechselweise an denselben Oszillatorkreis koppelbar ist.

7. Kapazitätsmesskreis nach einem der Ansprüche 2 bis 5, dadurch gekennzeichnet, daß die Ausgänge einer Mehrzahl von stromabfühlenden Operationsverstärkern ($A_1$-$A_N$) mit dazugehörigen frequenzbestimmenden Impedanzsätzen ($R_{T1}$, $C_{T1}$-$R_{TN}$, $C_{TN}$) mit Hilfe von schaltern (0) wechselweise an denselben Rückkopplungskreis koppelbar sind.

8. Kapazitätsmesskreis nach einem der vorhergehenden Ansprüche, dadurch gekennzeichnet, daß der erste Endanschluß (G) mit Erdpotential verbunden ist.

9. Kapazitätsmesskreis nach Anspruch 8, dadurch gekennzeichnet, dass die zu messende Kapazität ($C_T$) an dem mit Erdpotential verbundenen Ende des Impedanzsatzes ($R_T$, $C_T$) angeordnet ist.

**Revendications**

1. Circuit de mesure de capacitances comprenant un circuit oscillateur, où la capacitance ($C_T$) à mesurer forme un chaînon d'un groupe d'impédances en série déterminant la fréquence ($R_T$, $C_T$), qui est connecté au circuit oscillateur uniquement aux bornes extrêmes de la connexion en série, que l'on appellera ci-après la première borne extrême et la seconde borne extrême, caractérisé en ce que la première borne extrême (G) est connectée à une tension constante tandis que la seconde borne extrême (H) est connectée à un point (2) du circuit oscillateur où le circuit maintient une tension constante pendant chaque alternative tout en détectant en même temps le courant de charge s'écoulant dans la capacitance pour un déclenchement au moment où le courant de charge ainsi détecté a baissé à une valeur prédéterminée.

2. Circuit de mesure de capacitances selon la revendication 1 caractérisé en ce que la seconde borne extrême (H) est connectée à l'entrée inverse (2) d'un amplificateur opérationnel de détection de courant (A) ayant une impédance ($R_S$) connectée entre sa sortie (6) et son entrée inverse (2), et la sortie (6) est connectée à un circuit régénérateur de manière qu'à la baisse du courant de charge à la capacitance ($C_T$), détectée par l'amplificateur opérationnel (A), à une valeur prédéterminée, la tension de sortie déclenche le circuit régénérateur, dont la sortie (7) est recouplée à l'entrée directe (3) de l'amplificateur opérationnel (A) détectant le courant.

3. Circuit de mesure de capacitances selon la revendication 2 caractérisé en ce que le circuit générateur comprend un comparateur (K), dont l'entrée directe est couplée à la sortie (6) de l'amplificateur opérationnel de détection de courant tandis que son entrée inverse est couplée à une source de potentiel positif et négatif de référence ($U_{REF}+$/$U_{REF}-$).

4. Circuit de mesure de capacitances selon la revendication 3 caractérisé en ce que la sortie du comparateur (K) et connectée à l'entrée d'un amplificateur tampon (B), dont la sortie constitue la sortie (7) du circuit régénérateur et sert également de source de potentiel de référence pour le comparateur (K).

5. Circuit de mesure de capacitances selon la revendication 3 caractérisé en ce qu'un amplificateur inverseur (A¹) est inséré entre l'amplificateur opérationnel (A) détectant le courant et une bascule de Schmitt (S) qui constitue le comparateur.

6. Circuit de mesure de capacitances selon l'une quelconque des revendications précédentes caractérisé en ce qu'un certain nombre de groupes d'impédances en série déterminant la fréquence ($R_{T1}$, $C_{T1}$-$R_{TN}$, $C_{TN}$) peuvent être alternativement connectés dans le même circuit oscillateur au moyen de commutateurs (0).

7. Circuit de mesure de capacitances selon l'une quelconque des revendications 2 à 5 caractérisé en ce que les sorties d'un certain nombre d'amplificateurs opérationnels de détection de courant ($A_1$-$A_N$) avec des groupes d'impédances déterminant la fréquence ($R_{T1}$, $C_{T1}$-$R_{TN}$, $C_{TN}$) qui leur sont connectés, peuvent être alternativement connectées au même circuit régénérateur au moyen de commutateurs (0).

8. Circuit de mesure de capacitances selon l'une quelconque des revendications précédentes caractérisé en ce que la première borne extrême (G) est connectée à la masse.

9. Circuit de mesure de capacitances selon la revendication 8 caractérisé en ce que la capacitance ($C_T$) à mesurer est agencée à l'extrémité du groupe d'impédances ($R_T$, $C_T$) connecté à la masse.

FIG.1

FIG.2

$$U_A = U_K + R_S \cdot J_{RC}$$

FIG.3

FIG.4

FIG.5

FIG.6

FIG.7

FIG. 8

FIG. 9

FIG.10